# EUROPEAN PATENT SPECIFICATION

(11) **EP 0 841 569 B1**
(45) Date of publication and mention of the grant of the patent: **02.05.2003**
(21) Application number: 97308476.7
(22) Date of filing: 23.10.1997
(51) Int. Cl.: G01R 23/16

(54) **A spectrum analyser**
Spektralanalysator
Analyseur de spectre

(30) Priority: 07.11.1996 GB 9623242
(43) Date of publication of application: 13.05.1998
(73) Proprietor: IFR Limited, Stevenage, Herts SG1 2AN (GB)
(72) Inventor: Kikkert, Cornelis Jan, Annandale, Queensland 4811 (AU); Thomas, Neil Edwin, St. Albans, Herts, AL1 4UB (GB); Brown, Harold Thomas, Letchworth, Herts, SG6 2SX (GB)
(74) Representative: Pratt, David Martin

(56) References cited:
- US-A- 4 054 785
- US-A- 4 791 577
- US-A- 5 519 645
- "MODERN INSTRUMENTS EASE FREQUENCY ANALYSIS" EDN ELECTRICAL DESIGN NEWS, vol. 36, no. 10, 9 May 1991, pages 95-100, 102, XP000228540
- KAWABATA S ET AL: "A HIGH-PERFORMANCE 1.8-GHZ VECTOR NETWORK AND SPECTRUM ANALYZER" HEWLETT-PACKARD JOURNAL, vol. 44, no. 5, 1 October 1993, pages 76-84, XP000403455

## Description

This invention relates to the spectrum analysis of electronic signals, and in particular of radio frequency signals, comprising both unmodulated and modulated waves. These signals are typically used in radio communication. Spectrum analysis is an important tool at many stages of the design, installation and operation of radio communication links. The comparison of the spectrum taken at several points in the radio system allows impairments introduced by the components of that system to be determined. A very important measurement application of the spectrum analyser occurs because of its ability to be able to measure very low power signals in the presence of high power ones. This is required for instance when designing synthesisers or oscillators. In addition to the main output signal, many sources have in addition "spurious" signals which, although they may be at very low power, are still sufficient to cause degraded operation of the system in which they are used. Of course, the spectrum analyser is a receiver system and so is built with components that are capable of causing spurious signals. To be useful, a user must be confident that a small signal that he sees displayed on the analyser is due to signal being measured, and not due to spurious signals due to the analyser itself. One measure of the quality of a spectrum analyser is its "spurious free dynamic range". This is the difference in power between the largest signal that it is able to measure at a particular setting, and the smallest signal that is guaranteed not to be a spurious product of the spectrum analyser itself.

Spectrum analysers are typically implemented as a superheterodyne receiver, with a tuned detector measuring the power present in the final intermediate frequency (IF). This provides a single power measurement at the tuned frequency of the receiver. In order that the analyser may provide a picture of the power in a wider band, the receiver is swept from one frequency to another, with the measured power being displayed at a position on a display corresponding to the tuned frequency. As the analyser is built from oscillators, mixers and filters, there are many opportunities for spurious signals to be generated in the front end. Careful design can reduce these to a manageable level.

This type of spectrum analyser has been the only practical design since their introduction, and is still a dominant design. One drawback of this type of analyser is that the IF filter needs time to settle to an accurate reading. This time is dependent on its bandwidth. For wide bandwidths, this settling time is not a user problem, and a complete trace may typically be completed several times per second. For narrow bandwidths however, the time required for a sweep increases to the point that the user may have to wait 10, or even 100 seconds for a complete sweep. This is clearly undesirable.

A new architecture of analyser is now becoming more popular. This retains the receiver RF front end, but instead of detecting a narrow filtered IF, a wideband IF is digitised, and then Fourier transformed. The effect of this transform is to emulate many, typically 500 to 1000, filters in parallel. This gives the analyser a speed advantage of 500 to 1000 times over one implemented conventionally.

The weakest point of the new spectrum analyser architecture is the analogue to digital converter that digitises the final IF. While the digitiser easily outperforms the detector system on level accuracy and broad-band noise floor, it has the very serious drawback of a relatively high level of spurious signal generation, which will dominate the spurious free dynamic range and so limit the specification of the whole spectrum analyser.

The most basic technique for reducing the levels of spurious signals generated by the digitiser is to use dither. This is an extra signal added into the input of the converter. The overall effect of this signal addition is to remove the correspondence between the user's input signal and the level detected by the converter. At first sight this is not a desirable thing. However, the dither is carefully designed to be subtractable from the resulting digitised signal, either by occupying a different part of the frequency band, or by being accurately known and therefore subtractable. There are many schemes for adding and removing dither. They do improve matters, but do not result in ideal operation.

It is known that the spurious signals can be modelled as very high order harmonics, in that as the input frequency moves by some increment, the spurious signals move by a very much larger increment (except for the spurious at DC, which is the 0th harmonic and hence does not move at all).

One known receiver design disclosed in EP-A-0681371 uses the fact that mixer spurious products have just this different rate of movement from the main signal. In it, the local oscillator is swept, and digital processing is applied after digitisation to remove the effect of this frequency sweep from the main signal. This is done by a complex multiplication of the signal and a locally generated swept frequency reference which has to be synchronised with tuning sweep of the receiver front end. The synchronism of the sweeps is not a trivial task, and the complex multiplication following the digitiser requires a large amount of processing power. In this frequency shift/frequency deshift process, the spurious mixer products, along with spurious signals from the digitiser, are swept across a wide range of frequencies, reducing their averaged peak power. The prior art spectrum analyser of US 4791577 has a scheme for eliminating unwanted signal components in the frequency domain. Two spectra are captured using different frequencies of a local oscillator and the spectra are then compared and those parts of the spectra that do not concur are forced to zero.

The present invention seeks to reduce the level of spurious signals displayed to the user on a spectrum analyser implemented with a digital processing back end. The invention does not require a receiver that is swept in synchronism with a real time digital frequency shifter following the digitiser.

According to the present invention there is provided a spectrum analyser comprising: means for converting at each of a first and at least one further tuned setting thereof the frequency of a received radio frequency signal to a respective first and at least one further intermediate frequency; means for digitising each intermediate frequency signal; means for carrying out a frequency analysis of each digitised intermediate frequency signal to provide a respective power spectrum thereof; means for shifting the frequency of the power spectrum of the or each said further intermediate frequency signal so that the spectral line corresponding to the further intermediate frequency is shifted to the first intermediate frequency; means for combining the power spectrum of the first intermediate frequency signal with the shifted power spectrum(s) of the further intermediate frequency signal(s) such that any spurii present in the power spectrums due to operation of said spectrum analyser are attenuated as compared to spectral lines present in the power spectrums due to frequency components of said received radio frequency signal.

Preferably, said means for carrying out a frequency analysis provides the power spectrum of each digitised intermediate frequency signal by Fourier transforming the signal.

Preferably, each said tuned setting of said means for converting is achieved by tuning the frequency of a local oscillator of said means for converting, and the frequency difference between adjacent frequency settings of said local oscillator is equal to an integer multiple of the frequency interval of the power spectrums provided by said means for carrying out a frequency analysis.

Preferably, said means for combining determines the average power present in corresponding frequency intervals of said power spectrum of the first intermediate frequency signal and said shifted power spectrum(s) of the further intermediate frequency signal(s).

As an alternative to the previous paragraph, preferably, said means for combining determines the average of the logs of the powers present in corresponding frequency intervals of said power spectrum of the first intermediate frequency signal and said shifted power spectrum(s) of the further intermediate frequency signal(s).

As an alternative to the previous two paragraphs, preferably, said means for combining: determines which of corresponding frequency intervals of the power spectrums contain the N greatest powers, where N is a positive integer substantially less than the number of power spectrums; discards the N greatest powers; and determines the average power present in the corresponding frequency intervals with the N greatest powers discarded.

The invention will now be further described, by way of example, with reference to the accompanying drawings, in which:
Figure 1 is a block schematic diagram of a spectrum analyser in accordance with the present invention;
Figure 2 shows three power spectrums provided in use of the spectrum analyser of Figure 1; and
Figure 3 shows the three power spectrums of Figure 2 following frequency shifting thereof.

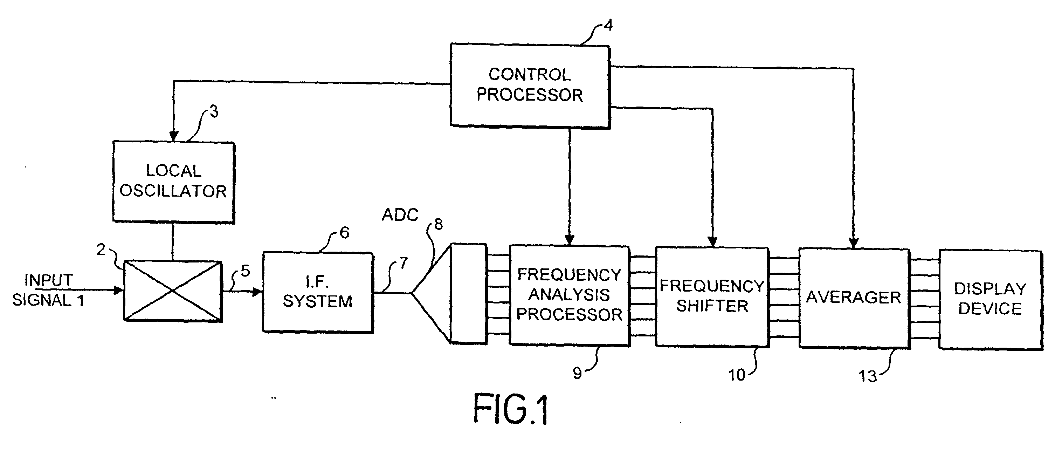

Referring to Figure 1, an input signal 1 is converted in frequency by a frequency mixer 2 which also receives a local oscillator signal from local oscillator 3 of known and controllable frequency. Control processor 4 selects the frequency at which the local oscillator is to operate. The output signal 5 from the mixer, which consists principally of the sum and difference frequencies of the input and local oscillator signals, goes into an IF system 6. The purpose of the IF system is to select just one mixing product, usually the difference frequency, filter it, and further convert its frequency to a lower fixed frequency at its output 7. This output frequency will typically be in the range 1 MHz to 30 MHz. An analogue to digital converter 8 converts this signal into a series of numerical values, which are converted by the frequency analysis processor 9 into a power spectrum.

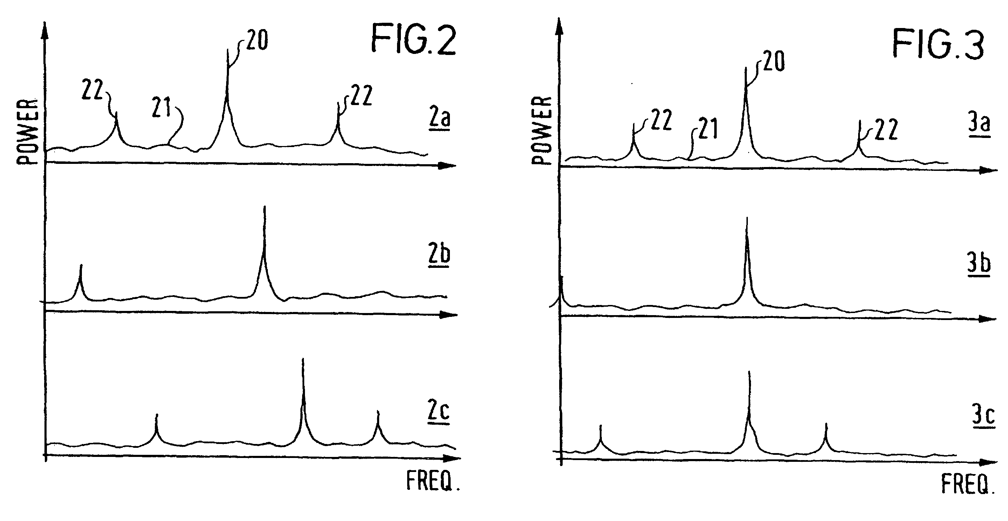

In this description, the signal is represented by the power that is present in each of a large number of spectral "bins" or frequencies. Referring to Figure 2a, there is a main signal peak 20, a noise floor 21, and some spurious signals 22 which are not present on the input. These have been generated by distortion processes within the input mixer, IF system and the digitiser.

It is required that several measurements are made of the spectrum. Between each of the measurements, the local oscillator 3 is stepped to a new, slightly different, frequency. As the receiver front end is tuned differently, the input signals will appear at a different frequency in the IF output, and hence appear in a different frequency resolution bin in the Fourier transform. The output of frequency analysis processor 9 over time is represented in Figure 2 (initial output Figure 2a, then Figure 2b, then Figure 2c). As the local oscillator is re-tuned, the main input signal is shifted to successively different bins. Importantly, the spurious signals however do not move with the input signal, but appear in bins at different offsets from the input signaL As the tuning frequency of the receiver is known, the apparent frequencies of the signals can be corrected by assigning the individual bin measurements to different frequencies. If the receiver frequency shift is an integral multiple of the Fourier transform resolution, then the frequency re-assignment may be simply done by re-indexing the bins, without any interpolation being required. This reassignment is carried out by frequency shifter 10. The output after this re-assignment is shown in Figure 3. The spectra have been shifted sideways to align the tuned frequency onto the same bin. The spurious signals have also been shifted.

The variance of a single power spectral measurement is very high. Practical spectrum analysers are therefore always required to average several measurements before the user can be confident in the display. The requirement to take the combination of several readings does not therefore create an unusual time penalty compared to a conventional spectrum analyser. The requirement to retune the local oscillator several times during one composite measurement does imply a requirement for a fast tuning synthesiser.

There are several ways of using the multiple readings in the averager 13. The averager has many independent channels, one for each resolution frequency calculated and displayed. The processing for one displayed bin uses all of the successive readings calculated and re-assigned to that bin. This processing takes place in parallel for all displayed bins.

One method is to take the power average of all of the readings. This is what is already done in most digitally based spectrum analysers. The power average is known to be the optimum method for detecting a signal in the presence of noise, as long as the noise is white. The effect of the averaging is to spread out the power of the spurious signal and hence reduce its excess of power over the local noise floor. It is important to note that this occurs, because, as the local oscillator is re-tuned to obtain the different readings, the spurii due to operation of the spectrum analyser do not move with the input signal. In the case of a spurious signal which was 10 dB above the local noise floor, an average of 10 readings would reduce the spurious to 3 dB above the local noise floor, spread over 10 different frequencies.

In the simplest conceptual method for achieving the foregoing averaging, the power measurements would first be loaded into a memory matrix, with one column for each frequency ordinate, and one row for each acquisition taken at a different frequency of local oscillator 3. The arithmetic mean of all the power measurements at each frequency would then be taken. This would be done by summing the powers in all rows of the matrix a column at a time, and dividing by the number of rows. However, the foregoing would not be an efficient use of memory, as the same answer could be obtained by keeping a running total of the measurements as they were made. Thus, the better solution is to use a memory matrix of only one row to hold the running sum of all the measurements made to date.

A second method of using the readings is to form the average of the logs of the readings. This is the effective operation of older types of spectrum analysers, where a video filter operates on the detected output of a logarithmic amplifier. For accurate measurements of the noise floor, this technique is known to be inferior to the first one. When a big signal, i.e. one uncontaminated by noise and hence with a consistent amplitude, is averaged, it makes no difference whether the average is performed before or after conversion to dB. When a noisy signal is averaged, the logarithmic operation will tend to give more weight to the small signals. It is well known that a conventional spectrum analyser will read a noise signal to be about 2.5 dB low with respect to a true power average. In the case of spurious reduction, this can be turned into a benefit. The effect of the log operation is to weight the lower power noise floor, at the expense of the higher power spurious signal. For the same 10 dB spurious signal over 10 averages, it is reduced to 1.3 dB above the noise floor using averages of logs, very much better than the true power average.

It is desirable to use an operation before the average which tends to diminish the effect of large signals. One such method would be to determine which of corresponding frequency intervals of the power spectrums contains the greatest power, to discard this greatest power, and to determine the average power present in the corresponding frequency intervals with this greatest power discarded. In other words, if a spurious signal makes one appearance in each bin as its apparent frequency is changed, its effect would be to put one high reading into each average that it appears in. If the maximum reading in each bin is discarded before averaging, then this will completely attenuate the spurious signal. It will also tend to reduce the average power reading. This reduction can be determined statistically, just as the 2.5 dB reduction is determined for post log averaging. The reduction is a function of the number of averages, and tends to zero for an infinite number of averages.

The method of the preceding paragraph could, of course, be generalised to take the arithmetic mean of the M-N smallest power measurements, where M is the total number of acquisitions, and N is a small integer representing the number of large readings that are excluded from the M-N that are averaged. This requires an N+1 row memory matrix. One row holds the running sum of all readings to date as previously mentioned. The other N rows hold the values of the N largest measurements. As each new acquisition is made, the value is summed into the running sum row, and compared with the N highest values to date. If the current value is larger than any of the largest to date, it replaces the smallest of those values. Once all acquisitions have been completed, the N largest values are subtracted from the total sum, effectively leaving a value that represents the sum of the M-N smallest values.

It is to be appreciated that although the analyser described by way of example alters its tuned setting by altering the frequency generated by local oscillator 3, an equivalent effect can be achieved by altering the frequency shift of IF system 6 together with the frequency generated by local oscillator 3, or by omitting local oscillator 3 and mixer 2 altogether, and altering the frequency shift of IF system 6 alone. In this case, IF system 6 would not convert to a fixed frequency at its output 7, and the frequency shift of IF system 6 would be controlled by control processor 4.

## Claims

1. A spectrum analyser comprising: means (2, 3) for converting at each of a first and at least one further tuned setting thereof the frequency of a received radio frequency signal (1) to a respective first and at least one further intermediate frequency; means (8) for digitising each intermediate frequency signal; means (9) for carrying out a frequency analysis of each digitised intermediate frequency signal to provide a respective power spectrum thereof; and means (10) for shifting the frequency of the power spectrum of the or each said further intermediate frequency signal so that the spectral line corresponding to the further intermediate frequency is shifted to the first intermediate frequency; and **characterised by**: means (13) for combining the power spectrum of the first intermediate frequency signal with the shifted power spectrums of the further intermediate frequency signals such that any spurii present in the power spectrums due to operation of said spectrum analyser are attenuated as compared to spectral lines present in the power spectrums due to frequency components of said received radio frequency signal.

2. An analyser according to claim 1 wherein said means for carrying out a frequency analysis is arranged to provide the power spectrum of each digitised intermediate frequency signal by Fourier transforming the signal.

3. An analyser according to claim 1 or claim 2 wherein said means for converting comprises a local oscillator (3) arranged to be tuned to provide each said tuned setting of said means for converting and wherein the frequency difference between adjacent frequency settings of said local oscillator is equal to an integer multiple of the frequency interval of the power spectrums provided by said means for carrying out a frequency analysis.

4. An analyser according to claim 1 or claim 2 or claim 3 wherein said means for combining is arranged to determine the average power present in corresponding frequency intervals of said power spectrum of the first intermediate frequency signal and said shifted power spectrums of the further intermediate frequency signals.

5. An analyser according to claim 1 or claim 2 or claim 3 wherein said means for combining is arranged to determine the average of the logs of the powers present in corresponding frequency intervals of said power spectrum of the first intermediate frequency signal and said shifted power spectrums of the further intermediate frequency signals.

6. An analyser according to claim 1 or claim 2 or claim 3 wherein said means for combining is arranged: to determine which of corresponding frequency intervals of the power spectrums contain the N greatest powers, where N is a positive integer substantially less than the number of power spectrums; to discard the N greatest powers; and to determine the average power present in the corresponding frequency intervals with the N greatest powers discarded.

## Patentansprüche

1. Spektralanalysator mit Einrichtungen (2, 3), mit denen in einer ersten sowie mindestens einer zweiten Abstimmeinstellung die Frequenz eines empfangenen Funksignals (1) zu einer ersten bzw. mindestens einer weiteren Zwischenfrequenz umsetzbar ist, einer Einrichtung (8), mit der jedes Zwischenfrequenzsignal digitalisiertbar ist, einer Einrichtung (9) zum Durchführen einer Frequenzanalyse jedes digitalisierten Zwischenfrequenzsignals zum Erstellen eines zugehörigen Leistungsspektrums sowie einer Einrichtung (10), mit der die Frequenz des Leistungsspektrums des einen oder der jeweiligen weiteren Zwischenfrequenzsignale verschiebbar ist derart, dass die der weiteren -Zwischenfrequenz entsprechende Spektrallinie auf die erste Zwischenfrequenz fällt, **gekennzeichnet durch** eine Einrichtung (13), mit der die Leistungsspektren des ersten mit dem/den verschobenen Leistungsspektren des/der weiteren Zwischenfrequenzsignale so kombinierbar sind, dass in den Leistungsspektren Störanteile aus dem Betrieb des Spektralanalysators gegenüber denjenigen Spektrallinien unterdrückt werden, die in den Leistungsspektren aus den Frequenzkomponenten des empfangenen Funkfrequenzsignals vorliegen.

2. Spektralanalysator nach Anspruch 1, bei dem die Einrichtung zur Frequenzanalyse so eingerichtet ist, dass das Leistungsspektrum jedes digitalisierten Zwischenfrequenzsignals durch Fourier-Transformation des Signals bereit gestellt wird.

3. Spektralanalysator nach Anspruch 1 oder 2, bei dem die Umsetzeinrichtung einen Zumischoszillator (3) aufweist, der in jede Abstimmeinstellung der Umsetzeinrichtung abstimmbar ist, wobei die Frequenzdifferenz zwischen nebeneinander liegenden Frequenzeinstellungen des Zumischoszillators gleich einem ganzzahligen Mehrfachen des Frequenzintervalls der Leistungsspektren ist, die die Einrichtung zum Durchführen einer Frequenzanalyse liefert.

4. Spektralanalysator nach Anspruch 1, 2 oder 3, dessen Kombiniereinrichtung so eingerichtet ist, dass sie den Durchschnittswert der Leistung in entsprechenden Frequenzintervallen der Leistungsspektren des ersten Zwischenfrequenzsignals und des/der verschobenen Leistungsspektren des/der weiteren Zwischenfrequenzsignale bestimmt.

5. Spektralanalysator nach Anspruch 1, 2 oder 3, dessen Kombiniereinrichtung so eingerichtet ist, dass sie den Durchschnittswert der Logarithmen der Leistungen bestimmt, die in entsprechenden Frequenzintervallen des Leistungsspektrums des ersten Zwischenfrequenzsignals und der verschobenen Leistungsspektren des/der weiteren Zwischenfrequenzsignale vorliegen.

6. Spektralanalysator nach Anspruch 1, 2 oder 3, dessen Kombiniereinrichtung so eingerichtet ist, dass sie bestimmt, welche von entsprechenden Frequenzintervallen der Leistungsspektren die N höchsten Leistungen enthalten, wobei N eine positive ganze Zahl und erheblich kleiner ist als die Anzahl der Leistungsspektren, dass sie weiterhin die N höchsten Leistungen verwirft und dass sie die durchschnittliche Leistung in den entsprechenden Frequenzintervallen mit den verworfenen N höchsten Leistungen bestimmt.

## Revendications

1. Analyseur de spectre comprenant :
. des moyens (2, 3) pour convertir un premier et au moins un signal supplémentaire réglé et accordé à la fréquence d'un signal de fréquence radio reçu (1) en respectivement une première et au moins une fréquence intermédiaire supplémentaire ;
. des moyens (8) pour numériser chaque signal de fréquence intermédiaire ;
. des moyens (9) pour effectuer une analyse de fréquence de chaque signal de fréquence intermédiaire numérisé afin de donner leur spectre de puissance respectif ; et
. des moyens (10) pour décaler la fréquence du spectre de puissance du ou de chacun desdits signaux de fréquence intermédiaire de sorte que la ligne spectrale correspondant à la fréquence intermédiaire supplémentaire soit décalée à la première fréquence intermédiaire ; et
**caractérisé par** :
. des moyens (13) pour combiner le spectre de puissance du premier signal de fréquence intermédiaire avec le ou les spectre(s) de puissance décalé(s) du ou des signal(aux) de fréquence intermédiaire supplémentaire(s) de sorte que tout parasite présent dans les spectres de puissance causé par le fonctionnement dudit analyseur de spectre soit atténué par rapport aux lignes spectrales présentes dans les spectres de puissance dues aux composantes de fréquence dudit signal de fréquence radio reçu.

2. Analyseur selon la revendication 1, dans lequel ledit moyen pour effectuer une analyse de fréquence est prévu pour fournir le spectre de puissance de chaque signal de fréquence intermédiaire numérisé en effectuant une transformation de Fourier du signal.

3. Analyseur selon la revendication 1 ou 2, dans lequel ledit moyen pour convertir comprend un oscillateur local (3) prévu pour être accordé afin de fournir chacun desdits réglages accordés desdits moyens pour convertir et dans lequel la différence de fréquence entre les réglages de fréquence adjacente dudit oscillateur local est égale à un multiple entier de l'intervalle de fréquence des spectres de puissance fournis par ledit moyen pour effectuer une analyse de fréquence.

4. Analyseur selon la revendication 1, 2 ou 3, dans lequel ledit moyen pour combiner est prévu pour déterminer la puissance moyenne présente dans des intervalles de fréquence correspondants dudit spectre de puissance du premier signal de fréquence intermédiaire et le ou les spectre(s) de puissance décalé(s) du ou des signal(aux) de fréquence intermédiaire.

5. Analyseur selon la revendication 1, 2 ou 3, dans lequel ledit moyen pour combiner est prévu pour déterminer la moyenne des logarithmes des puissances présentes dans les intervalles de fréquence correspondants du spectre de puissance du premier signal de fréquence intermédiaire et du ou des spectre(s) de puissance décalé(s) du ou des signal(aux) de fréquence intermédiaire supplémentaire.

6. Analyseur selon la revendication 1, 2 ou 3, dans lequel le moyen pour combiner est prévu pour :
. déterminer lequel des intervalles de fréquence correspondants des spectres de puissance contient les N plus grandes puissances, où N est un entier positif sensiblement inférieur au nombre de spectres de puissance ;
. éliminer les N plus grandes puissances ; et
. déterminer la puissance moyenne présente dans les intervalles de fréquence correspondants avec les N plus grandes puissances éliminées.
